# EUROPÄISCHE PATENTSCHRIFT

(11) **EP 3 131 127 B1**
(45) Veröffentlichungstag und Bekanntmachung des Hinweises auf die Patenterteilung: **31.01.2018**
(21) Anmeldenummer: 16181773.9
(22) Anmeldetag: 08.04.2011
(51) Int. Cl.: H01L 33/14, H01L 33/30, H01L 33/38, H01L 33/40

(54) **LEUCHTDIODENCHIP MIT STROMAUFWEITUNGSSCHICHT**
LIGHT-EMITTING DIODE CHIP WITH CURRENT SPREADING LAYER
PUCE POUR DIODE ELECTROLUMINESCENTE COMPRENANT UNE COUCHE D'EVASEMENT DU COURANT

(30) Priorität: 12.04.2010 DE 102010014667
(43) Veröffentlichungstag der Anmeldung: 15.02.2017
(62) Teilanmeldung aus: 11714027.7
(73) Patentinhaber: Osram Opto Semiconductors Gmbh, 93055 Regensburg (DE)
(72) Erfinder: Sundgren, Petrus, 93138 Lappersdorf (DE); Baur, Elmar, 93049 Regensburg (DE); Hohenadler, Martin, 93055 Regensburg (DE); Hofmann, Clemens, 93073 Neutraubling (DE)
(74) Vertreter: Epping - Hermann - Fischer

(56) Entgegenhaltungen:
- DE-A1-102005 029 272
- DE-A1-102007 022 947
- JP-A- 2004 356 601
- US-A1- 2007 075 327
- US-B1- 6 426 518

## Beschreibung

Diese Patentanmeldung beansprucht die Priorität der deutschen Patentanmeldung 10 2010 014 667.6. Bei Leuchtdiodenchips wird in der Regel zwischen dem elektrischen Kontakt und der Licht emittierenden Halbleiterschichtenfolge eine vergleichsweise dicke Stromaufweitungsschicht aus einem Halbleitermaterial mit guter elektrischer Leitfähigkeit angeordnet, um einen möglichst gleichmäßigen Stromfluss durch die aktive Schicht zu erzielen.

Beispielsweise ist aus der Druckschrift US 6,426,518 B1 ein Leuchtdiodenchip bekannt, bei dem der Licht emittierende Bereich auf einem Phosphid-Verbindungshalbleiter basiert, wobei zwischen dem elektrischen Kontakt und dem Licht emittierenden Bereich eine Stromaufweitungsschicht aus p-AlGaAs angeordnet ist. Die Stromaufweitungsschicht weist eine Dicke zwischen 1 µm und 10 µm auf. Ein weiterer Leuchtdiodenchip ist aus DE 10 2007 022947 A1 bekannt. Es hat sich herausgestellt, dass sich mit solchen vergleichsweise dicken Stromaufweitungsschichten aus AlGaAs eine gute Stromaufweitungsschicht erzielen lässt, aber andererseits auch ein nicht unerheblicher Anteil der emittierten Strahlung absorbiert wird. Die Absorption einer dicken Stromaufweitungsschicht ist insbesondere dann nicht vernachlässigbar, wenn die emittierte Strahlung kurzwellig ist und/oder oder Aluminiumanteil in der Stromaufweitungsschicht gering ist. Weiterhin hat sich herausgestellt, dass eine Erhöhung des Aluminiumanteils in der Stromaufweitungsschicht die Empfindlichkeit des Leuchtdiodenchips gegenüber Feuchtigkeit erhöht.

Der Erfindung liegt die Aufgabe zugrunde, einen Leuchtdiodenchip anzugeben, der eine Stromaufweitungsschicht aufweist, die eine geringe optische Absorption und gleichzeitig eine geringe Empfindlichkeit gegenüber Feuchtigkeit aufweist.

Diese Aufgabe wird durch einen Leuchtdiodenchip gemäß dem Patentanspruch 1 gelöst. Vorteilhafte Ausgestaltungen und Weiterbildungen der Erfindung sind Gegenstand der abhängigen Ansprüche.

Der Leuchtdiodenchip enthält gemäß zumindest einer Ausführungsform eine Halbleiterschichtenfolge, die ein Phosphid-Verbindungshalbleitermaterial aufweist. Insbesondere umfasst die Halbleiterschichtenfolge mehrere Schichten aus InₓGa_{y}Al_{1-x-y}P mit 0 ≤ x ≤ 1, 0 ≤ y ≤ 1 und x + y ≤ 1.

Die Halbleiterschichtenfolge enthält insbesondere einen p-Typ Phosphidverbindungshalbleiterbereich, einen n-Typ Phosphidverbindungshalbleiterbereich und eine zwischen dem p-Typ Phosphidverbindungshalbleiterbereich und dem n-Typ Phosphidverbindungshalbleiterbereich angeordnete aktive Schicht zur Emission elektromagnetischer Strahlung.

Die aktive Schicht kann z. B. als pn-Übergang, als Doppelheterostruktur, als Vielfachheterostruktur, als Einfach-Quantentopfstruktur oder Mehrfach-Quantentopfstruktur ausgebildet sein. Die Bezeichnung Quantentopfstruktur umfasst dabei jegliche Struktur, bei der Ladungsträger durch Einschluss (confinement) eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte oder Quantenpunkte und jede Kombination dieser Strukturen.

Bei dem Leuchtdiodenchip ist der n-Typ Halbleiterbereich einer Strahlungsaustrittsfläche des Leuchtdiodenchips zugewandt, und der p-Typ Halbleiterbereich ist einem Träger des Leuchtdiodenchips zugewandt. Vorzugsweise handelt es sich bei dem Leuchtdiodenchip um einen so genannten Dünnfilm-Leuchtdiodenchip, bei dem ein zum Aufwachsen der Halbleiterschichtenfolge verwendetes Aufwachssubstrat von dem Leuchtdiodenchip abgelöst ist. Das ursprüngliche Aufwachssubstrat kann insbesondere vom n-Typ Halbleiterbereich der Halbleiterschichtenfolge abgelöst sein. An der Seite des dem ursprünglichen Aufwachssubstrat gegenüberliebenden p-Typ Halbleiterbereichs ist der Leuchtdiodenchip vorzugsweise mit dem Träger verbunden, beispielsweise mittels einer Lötverbindung. Der Träger ist in diesem Fall von einem Aufwachssubstrat der Halbleiterschichtenfolge verschieden und weist vorzugsweise Silizium, Molybdän oder Germanium auf. Im Gegensatz zu herkömmlichen LEDs, bei denen in der Regel der n-Typ Halbleiterbereich dem Substrat und der p-Typ Halbleiterbereich der Strahlungsaustrittsfläche zugewandt ist, ist bei dem Leuchtdiodenchip der p-Typ Halbleiterbereich dem Träger und der n-Typ Halbleiterbereich der Strahlungsaustrittsfläche zugewandt.

Zwischen dem Träger und dem p-Typ Halbleiterbereich ist eine weniger als 500 nm dicke Stromaufweitungsschicht angeordnet, die aus einer oder mehreren p-dotierte (n) AlₓGa₁₋ₓAs-Schicht(en) mit 0,5 < x ≤ 1 besteht.

Dadurch, dass die Stromaufweitungsschicht zwischen dem Träger und dem p-Typ Halbleiterbereich angeordnet ist, ist sie besser gegen Oxidation und/oder die Einwirkung von Feuchtigkeit geschützt, als wenn sie an der Strahlungsaustrittsseite des Leuchtdiodenchips an das Umgebungsmedium, insbesondere Luft, angrenzen würde.

Es hat sich weiterhin herausgestellt, dass eine weniger als 500 nm dicke Stromaufweitungsschicht eine geringere Empfindlichkeit gegen Oxidation und/oder Feuchtigkeit aufweist als vergleichsweise dicke Stromaufweitungsschichten. Dies beruht möglicherweise darauf, dass sich das Volumen einer AlGaAs-Schicht vergrößert, wenn die Schicht teilweise oxidiert. Dieser Effekt ist bei der Stromaufweitungsschicht, die nur weniger als 500 nm dick ist, weniger ausgeprägt als bei einer dickeren Schicht.

Durch die geringe Dicke der Stromaufweitungsschicht von weniger als 500 nm wird weiterhin die benötigte Wachstumszeit für die Stromaufweitungsschicht vorteilhaft reduziert. Da das Wachstum der Stromaufweitungsschicht bei erhöhten Temperaturen stattfindet, reduziert sich durch die Verringerung der Wachstumszeit auch die Diffusion von Fremdstoffen aus der benachbarten Halbleiterschichtenfolge in die Stromaufweitungsschicht, beispielsweise die Diffusion von Dotierstoffen wie Mg und Zn aus dem p-Typ Halbleiterbereich der Halbleiterschichtenfolge.

Die geringe Dicke der Stromaufweitungsschicht von weniger als 500 nm reduziert weiterhin vorteilhaft die optische Absorption in der Stromaufweitungsschicht. In der aktiven Schicht der Halbleiterschichtenfolge emittierte Strahlung, die zunächst in Richtung der Stromaufweitungsschicht und des Trägers emittiert wird, wird daher geringer in der Stromaufweitungsschicht absorbiert als im Fall einer wesentlich dickeren Stromaufweitungsschicht. Die in Richtung des Trägers emittierte Strahlung wird vorzugsweise durch eine auf dem Träger angeordnete Spiegelschicht in Richtung zu einer Strahlungsaustrittsseite des Leuchtdiodenchips reflektiert.

Die optische Absorption in der Stromaufweitungsschicht ist vorteilhaft auch deshalb vergleichsweise gering, da die eine oder die mehreren p-dotierten AlₓGa₁₋ₓAs-Schichten, welche die Stromaufweitungsschicht ausbilden, einen Aluminiumanteil x > 0,5 aufweisen. Aufgrund des vergleichsweise großen Aluminiumanteils weist die Stromaufweitungsschicht eine vergleichsweise große elektronische Bandlücke auf, durch die sich die Absorption der Strahlung vermindert.

Bei einer bevorzugten Ausgestaltung weist die Stromaufweitungsschicht eine Dicke von weniger als 300 nm auf. Dadurch wird die Stabilität der Schicht gegenüber Oxidation und/oder Einwirkung von Feuchtigkeit weiter verbessert und die optische Absorption vermindert.

Besonders vorteilhaft ist es, wenn für den Aluminiumanteil x in der Stromaufweitungsschicht 0,6 ≤ x ≤ 0,8 gilt. In diesem Fall lässt sich insbesondere eine geringe optische Absorption in der Stromaufweitungsschicht erzielen.

Bei der Stromaufweitungsschicht kann es sich um eine Einzelschicht aus AlₓGa₁₋ₓAs oder um mehrere Teilschichten aus AlₓGa₁₋ₓAs handeln. Für den Fall, dass die Stromaufweitungsschicht aus mehreren Teilschichten zusammengesetzt ist, gelten die hier und im Folgenden beschriebenen vorteilhaften Ausgestaltungen der Stromaufweitungsschicht für die Gesamtheit der Teilschichten. Insbesondere beträgt die Dicke einer aus mehreren Teilschichten zusammengesetzten Stromaufweitungsschicht insgesamt weniger als 500 nm oder besonders bevorzugt sogar insgesamt weniger als 300 nm.

Die Stromaufweitungsschicht weist vorteilhaft eine Dotierstoffkonzentration von mehr als 1 x 10¹⁹ cm⁻³ auf. Besonders bevorzugt beträgt die Dotierstoffkonzentration in der Stromaufweitungsschicht mindestens 5 x 10¹⁹ cm⁻³. Durch eine hohe Dotierstoffkonzentration wird vorteilhaft eine hohe elektrische Leitfähigkeit in der Stromaufweitungsschicht erzielt.

Bei einer bevorzugten Ausgestaltung umfasst die Stromaufweitungsschicht C als Dotierstoff. Es hat sich vorteilhaft herausgestellt, dass sich mit C als Dotierstoff in AlGaAs-Schichten hohe Dotierstoffkonzentrationen mit guter Reproduzierbarkeit erzielen lassen können.

Bei einer weiteren bevorzugten Ausgestaltung ist die Stromaufweitungsschicht einschließlich ihrer Seitenflanken mit einer Verkapselungsschicht versehen. Die Verkapselungsschicht kann insbesondere Siliziumoxid, Siliziumnitrid, ein transparentes leitfähiges Oxid wie beispielsweise Zinkoxid oder ein Metall enthalten. Um auch die Seitenflanken der Stromaufweitungsschicht mit einer Verkapselungsschicht versehen zu können, kann die Stromaufweitungsschicht beispielsweise vor dem Aufbringen der Verkapselungsschicht strukturiert werden. Bei der Strukturierung können beispielsweise Randbereiche der Stromaufweitungsschicht abgetragen werden, sodass eine nachträglich mit einem Beschichtungsverfahren aufgebrachte Verkapselungsschicht auch die Seitenflanken der Stromaufweitungsschicht bedeckt. Durch die Verkapselungsschicht wird insbesondere die Empfindlichkeit der Stromaufweitungsschicht gegenüber Umwelteinflüssen, insbesondere gegenüber Oxidation und/oder die Einwirkung von Feuchtigkeit, weiter verringert. Es ist möglich, dass die Verkapselungsschicht in verschiedenen Teilbereichen verschiedene Materialien enthält. Beispielsweise kann die Verkapselungsschicht in Teilbereichen aus einem elektrisch isolierenden Material wie beispielsweise Siliziumoxid oder Siliziumnitrid gebildet sein, während sie in anderen Bereichen aus einem elektrisch leitfähigen Material wie beispielsweise Zinkoxid oder aus einem Metall gebildet ist. Die elektrisch leitfähigen Teilbereiche der Verkapselungsschicht dienen in diesem Fall insbesondere zur Stromeinprägung in die Stromaufweitungsschicht.

Bei einer weiteren bevorzugten Ausgestaltung weist die Stromaufweitungsschicht schräge Seitenflanken auf, die um einen Winkel zwischen einschließlich 20° und einschließlich 70° zur Schichtebene der Stromaufweitungsschicht geneigt sind. Auf diese Weise kann die Strahlungsauskopplung aus dem optoelektronischen Bauelement verbessert werden. Insbesondere können die schrägen Seitenflanken der Stromaufweitungsschicht als Mikroprismen fungieren, durch die in der aktiven Schicht emittierte Strahlung, die in Richtung des Trägers emittiert wird, zur Strahlungsaustrittsseite des Leuchtdiodenchips hin reflektiert wird. Es ist möglich, dass sich die schrägen Seitenflanken bis in die Phosphidverbindungs-Halbleiterschichtenfolge hinein erstrecken, so dass auch eine oder mehrere Schichten der Halbleiterschichtenfolge schräge Seitenflanken aufweisen.

Bei einer weiteren vorteilhaften Ausgestaltung ist mindestens ein Graben in der Stromaufweitungsschicht ausgebildet. Der mindestens eine Graben ist vorzugsweise mit Siliziumnitrid, Siliziumoxid, Zinkoxid oder einem Metall aufgefüllt. Im Bereich des Grabens der Stromaufweitungsschicht grenzt das Füllmaterial direkt an den p-Typ Halbleiterbereich an. Durch den Graben kann gezielt ein Strompfad durch die Halbleiterschichtenfolge definiert werden. Es ist vorteilhaft auch möglich, dass sich der mindestens eine Graben bis in den p-Typ Phosphidverbindungshalbleiterbereich hinein erstreckt.

Bei der vorliegenden Erfindung grenzt mindestens eine Schicht aus InₓGa_{y}Al_{1-x-y}As mit 0 ≤ x ≤ 1, 0 ≤ y ≤ 1 und x + y ≤ 1 an die Stromaufweitungsschicht an, die eine geringere Bandlücke und eine geringere Dotierstoffkonzentration als die Stromaufweitungsschicht aufweist. An der Grenzfläche zwischen der Stromaufweitungsschicht und der Schicht mit der geringeren Bandlücke und geringeren Dotierstoffkonzentration tritt in diesem Fall jeweils eine Verbiegung der Bandkanten des Leitungsbandes und des Valenzbandes auf, die zur Ausbildung eines zweidimensionalen Löchergases mit hoher Leitfähigkeit führt. Auf diese Weise lassen sich gezielt Bereiche mit hoher Ladungsträgerkonzentration und Ladungsträgerbeweglichkeit erzeugen.

Es ist möglich, dass die mindestens eine AlGaAs-Schicht in der Stromaufweitungsschicht einen geringen Anteil eines oder mehrerer weiterer Elemente enthält. Der Anteil des einen oder der mehreren weiteren Elemente in der Stromaufweitungsschicht beträgt in diesem Fall weniger als 10 %. Bei dem einen oder den mehreren weiteren Elementen kann es sich um Dotierstoffe handeln, oder um geringe Mengen eines weiteren Materials der dritten oder fünften Hauptgruppe des Periodensystems.

Die Erfindung wird im Folgenden anhand von Ausführungsbeispielen im Zusammenhang mit den Figuren 1 bis 5 näher erläutert.

Es zeigen:
- Figur 1: eine schematische Darstellung eines Querschnitts durch einen Leuchtdiodenchip gemäß einem ersten Ausführungsbeispiel,
- Figur 2: eine schematische Darstellung eines Querschnitts durch einen Leuchtdiodenchip gemäß einem zweiten Ausführungsbeispiel,
- Figur 3: eine schematische Darstellung eines Querschnitts durch einen Leuchtdiodenchip gemäß einem dritten Ausführungsbeispiel,
- Figur 4: eine schematische Darstellung eines Querschnitts durch einen Leuchtdiodenchip gemäß einem vierten Ausführungsbeispiel,
- Figur 5: eine schematische Darstellung eines Querschnitts durch einen Leuchtdiodenchip gemäß einem fünften Ausführungsbeispiel.

Gleiche oder gleich wirkende Elemente sind in den Figuren mit den gleichen Bezugszeichen versehen. Die Größen der einzelnen Elemente sowie die Größenverhältnisse der Elemente untereinander sind nicht als maßstabsgerecht anzusehen.

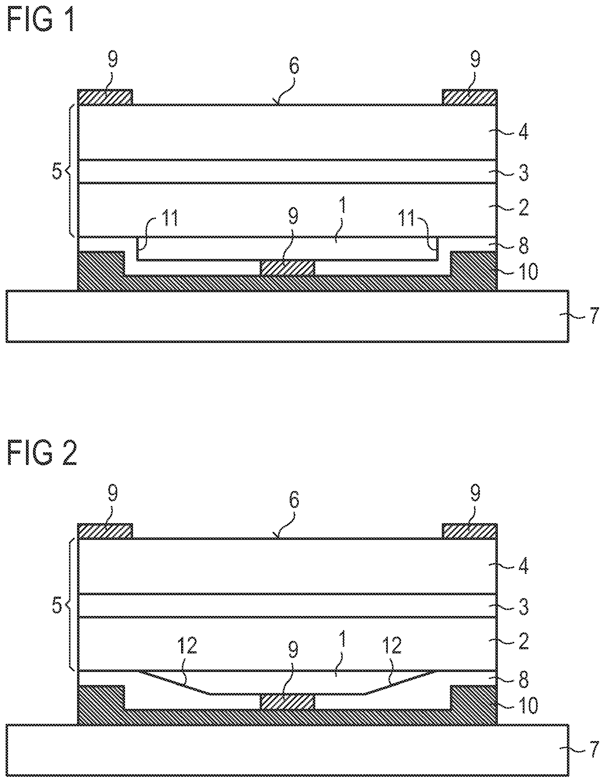

Der in Figur 1 dargestellte Dünnfilm-Leuchtdiodenchip enthält eine Halbleiterschichtenfolge 5, die einen p-Typ Halbleiterbereich 2 und einen n-Typ Halbleiterbereich 4 aufweist. Zwischen dem p-Typ Halbleiterbereich 2 und dem n-Typ Halbleiterbereich 4 ist eine aktive Schicht 3 angeordnet. Die aktive Schicht 3 weist vorzugsweise eine Einfach- oder Mehrfach-Quantentopfstruktur auf.

Die Halbleiterschichtenfolge 5 basiert auf einem Phosphid-Verbindungshalbleiter, d. h. die in der Halbleiterschichtenfolge 5 enthaltenen Halbleiterschichten weisen insbesondere InₓGa_{y}Al_{1-x-y}P mit 0 ≤ x ≤ 1, 0 ≤ y ≤ 1 und x + y ≤ 1 auf. Insbesondere sind der p-Typ Halbleiterbereich 2, die aktive Schicht 3 und der n-Typ Halbleiterbereich aus Phosphidverbindungshalbleitermaterialien gebildet.

Bei dem Leuchtdiodenchip handelt es sich um eine so genannte Dünnfilm-LED, bei der ein zum Aufwachsen der Halbleiterschichtenfolge 5 verwendetes Aufwachssubstrat von der Halbleiterschichtenfolge 5 abgelöst wurde. Insbesondere kann das Aufwachssubstrat von dem n-Typ Halbleiterbereich 4 abgelöst sein, der nun die Strahlungsaustrittsfläche 6 des Leuchtdiodenchips aufweist. An einer dem ursprünglichen Aufwachssubstrat und der Strahlungsaustrittsfläche 6 gegenüberliegenden Seite ist der Leuchtdiodenchip mit einem Träger 7 verbunden, der vorzugsweise Silizium, Germanium oder Molybdän aufweist. Bei dem Dünnfilm-Leuchtdiodenchip ist somit der n-Typ Halbleiterbereich 4 der Strahlungsaustrittsfläche 6 und der p-Typ Halbleiterbereich 2 dem Träger 7 zugewandt.

Zwischen dem Träger 7 und dem p-Typ-Phosphidverbindungshalbleiterbereich 2 ist eine Stromaufweitungsschicht 1 angeordnet. Bei der Stromaufweitungsschicht 1 handelt es sich um eine p-dotierte AlₓGa₁₋ₓAs-Schicht mit 0,5 < x ≤ 1, die eine Dicke von weniger als 500 nm aufweist.

Bevorzugt beträgt die Dicke der Stromaufweitungsschicht 1 sogar nur weniger als 300 nm. Für den Aluminiumanteil x in der Stromaufweitungsschicht 1 gilt bevorzugt 0,6 ≤ x ≤ 0,8.

Die Stromaufweitungsschicht 1 grenzt an einer dem Träger 7 zugewandten Seite zumindest in Teilbereichen an einen elektrischen Kontakt 9 an. Mindestens ein weiterer elektrischer Kontakt 9 des Leuchtdiodenchips ist beispielsweise auf der dem Träger gegenüberliegenden Strahlungsaustrittsseite 6 des Leuchtdiodenchips angeordnet. Die Stromaufweitungsschicht 1 weist bevorzugt eine Dotierstoffkonzentration von mehr als 1 x 10¹⁹ cm⁻³ und besonders bevorzugt von mehr als 5 x 10¹⁹ cm⁻³ auf. Auf diese Weise wird eine hohe Querleitfähigkeit der Stromaufweitungsschicht 1 erzielt, sodass die Halbleiterschichtenfolge 5 auch dann vergleichsweise homogen von einem Strom durchflossen wird, wenn der rückseitige Kontakt 9 beispielsweise nur auf einen kleinen zentralen Bereich der Stromaufweitungsschicht 1 aufgebracht ist.

Aufgrund ihrer geringen Dicke von weniger als 500 nm oder bevorzugt von weniger als 300 nm und des hohen Aluminium-Gehalts von mehr als 0,5 weist die Stromaufweitungsschicht 1 eine vorteilhaft geringe optische Absorption auf. Weiterhin hat sich herausgestellt, dass eine derart dünne Stromaufweitungsschicht 1 weniger empfindlich gegenüber Oxidation oder die Einwirkung von Feuchtigkeit ist als vergleichsweise dicke herkömmliche Stromaufweitungsschichten, die typischerweise eine Dicke von 1 µm oder mehr aufweisen. Trotz der geringen Dicke wird mit der Stromaufweitungsschicht 1 eine gute Stromaufweitung erzielt, wobei es vorteilhaft ist, wenn die Stromaufweitungsschicht 1 eine Dotierstoffkonzentration von mindestens 1 x 10¹⁹ cm⁻³ und besonders bevorzugt von mindestens 5 x 10¹⁹ cm⁻³ aufweist.

Es ist weiterhin vorteilhaft, dass die an den p-Typ Halbleiterbereich 2 angrenzende Stromaufweitungsschicht 1 zwischen dem Träger 7 und dem p-Typ Halbleiterbereich 2 angeordnet ist, da sie bei dieser Anordnung besser vor äußeren Einflüssen wie Oxidation oder Feuchtigkeit geschützt ist, als wenn sie an der Oberfläche des Leuchtdiodenchips an das Umgebungsmedium angrenzen würde.

Es ist möglich, dass die Stromaufweitungsschicht 1 aus mehreren Teilschichten (nicht dargestellt) aus AlₓGa₁₋ₓAs mit jeweils 0,5 < x ≤ 1 zusammengesetzt ist, wobei sich die Teilschichten beispielsweise in ihrer Dotierstoffkonzentration und/oder in ihrem Aluminiumgehalt voneinander unterscheiden können. In diesem Fall wird im Rahmen dieser Anmeldung die Gesamtheit der Teilschichten als Stromaufweitungsschicht 1 angesehen, sodass insbesondere die Gesamtdicke aller Teilschichten geringer als 500 nm und vorzugsweise geringer als 300 nm ist. Es ist auch denkbar, dass die Stromaufweitungsschicht 1 oder die Teilschichten der Stromaufweitungsschicht geringe Mengen an zusätzlichen Materialien aufweisen, deren Anteil aber insgesamt weniger als 10 % beträgt.

Um die Stromaufweitungsschicht 1 noch besser vor äußeren Einflüssen zu schützen, ist sie vorzugsweise einschließlich ihrer Seitenflanken 11 mit einer Verkapselungsschicht 8 versehen. Die Verkapselungsschicht 8 kann insbesondere ein transparentes dielektrisches Material wie beispielsweise Siliziumnitrid oder Siliziumoxid aufweisen. Alternativ ist es aber auch möglich, dass die Verkapselungsschicht 8 ein transparentes leitfähiges Oxid wie beispielsweise Zinkoxid oder ein Metall aufweist. Insbesondere im Fall einer Verkapselungsschicht 8 aus einem dielektrischen Material kann der elektrische Kontakt 9 für die Stromaufweitungsschicht 1 in einer Ausnehmung der Verkapselungsschicht 8 angeordnet sein.

Zwischen der Verkapselungsschicht 8, dem elektrischen Kontaktschicht 9 und dem Träger 7 ist eine Schichtenfolge 10 aus einem Metall oder einer Metalllegierung angeordnet. Die metallischen Schichten 10 können beispielsweise eine Spiegelschicht zur Reflexion der aus der aktiven Schicht 3 in die Richtung des Trägers 7 emittierten Strahlung enthalten. Weiterhin können die metallischen Schichten 10 auch eine Lotschicht zur Verbindung des Leuchtdiodenchips mit dem Träger 7 aufweisen.

Das in Figur 2 dargestellte Ausführungsbeispiel eines Leuchtdiodenchips unterscheidet sich von dem Ausführungsbeispiel der Figur 1 dadurch, dass die Stromaufweitungsschicht 1 schräge Seitenflanken 12 aufweist. Die schrägen Seitenflanken 12 schließen vorzugsweise mit der Schichtebene der Stromaufweitungsschicht 1 einen Winkel zwischen einschließlich 20° und 70° ein. Es hat sich herausgestellt, dass durch die schrägen Seitenflanken 12 der Stromaufweitungsschicht 1 die Strahlungsauskoppelung aus dem Leuchtdiodenchip verbessert werden kann. Aufgrund der Brechungsindexdifferenz zwischen der Stromaufweitungsschicht 1 und der Verkapselungsschicht 8 wirken die schrägen Seitenflanken 12 als Reflektoren, die Strahlung in Richtung zur Strahlungsaustrittsfläche 6 hin reflektieren können. Insbesondere ist es möglich, dass die gegenüberliegenden schrägen Seitenflanken 12 der Stromaufweitungsschicht 1 ein Mikroprisma ausbilden. Es ist auch möglich, dass sich die schrägen Seitenflanken 12 bis in Halbleiterschichtenfolge 5 erstrecken (nicht dargestellt).

Hinsichtlich der weiteren vorteilhaften Ausgestaltungen entspricht das in Figur 2 dargestellte Ausführungsbeispiel dem ersten Ausführungsbeispiel.

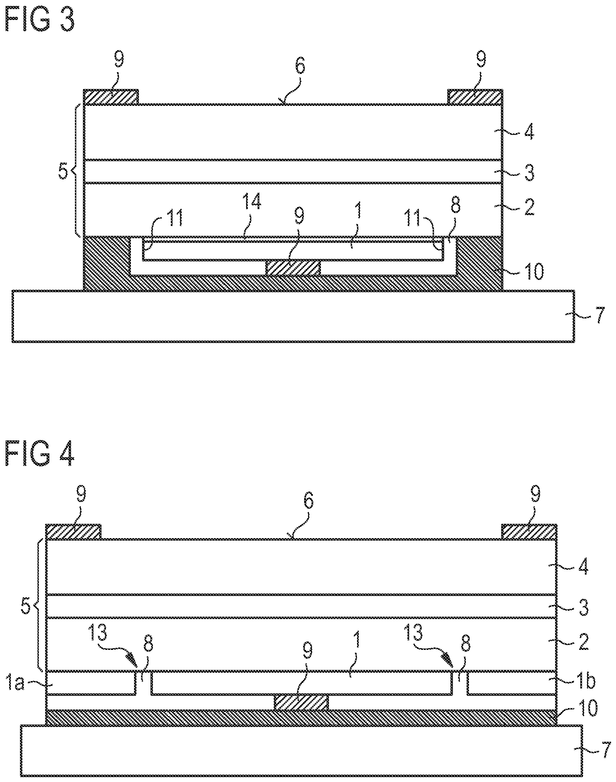

Das in Figur 3 dargestellte Ausführungsbeispiel eines Leuchtdiodenchips unterscheidet sich von dem in Figur 1 dargestellten Ausführungsbeispiel dadurch, dass die metallische Schichtenfolge 10 im Bereich der Seitenflanken des Leuchtdiodenchips bis an den p-Typ Halbleiterbereich 2 heranreicht. Somit wird die Stromaufweitungsschicht 1 einschließlich ihrer Seitenflanken 11 von der Verkapselungsschicht 8 umschlossen, und die Verkapselungsschicht 8 wird von der metallischen Schichtenfolge 10 umschlossen. Auf diese Weise wird eine besonders gute Beständigkeit der Stromaufweitungsschicht 1 gegenüber Oxidation oder das Einwirken von Feuchtigkeit erzielt.

Das in Figur 3 dargestellte Ausführungsbeispiel unterscheidet sich von dem in Figur 1 dargestellten Ausführungsbeispiel weiterhin dadurch, dass an die Stromaufweitungsschicht 1 eine InₓGa_{y}Al_{1-x-y}As-Schicht 14 mit 0 ≤ x ≤ 1, 0 ≤ y ≤ 1 und x + y ≤ 1 angrenzt, die eine geringere Dotierstoffkonzentration und eine geringere Bandlücke aufweist als die Stromaufweitungsschicht 1. Die Schicht 14 ist vorzugsweise zwischen der Stromaufweitungsschicht 1 und dem p-Typ Halbleiterbereich 2 angeordnet. Die Schicht 14 bildet an der Grenzfläche zur höher dotierten Stromaufweitungsschicht 1 eine Potenzialmulde aus, in der sich freie Ladungsträger in Form von Löchern sammeln. Die Löcher bilden in der Schicht 14 ein so genanntes zweidimensionales Löchergas aus. Auf diese Weise wird eine besonders hohe Querleitfähigkeit in der Schicht 14 erzielt.

Bei dem in Figur 4 dargestellten Ausführungsbeispiel eines Leuchtdiodenchips sind zwei Gräben 13 in der Stromaufweitungsschicht 1 ausgebildet, in die die Verkapselungsschicht 8 hineinragt. Der Bereich der Stromaufweitungsschicht 1, der zwischen den Gräben 13 angeordnet ist, ist mittels des elektrischen Kontakts 9 und die metallische Schichtenfolge 10 elektrisch angeschlossen. Die Randbereiche 1a, 1b der Stromaufweitungsschicht 1 sind dagegen nicht elektrisch angeschlossen. Auf diese Weise wird die Strahlungserzeugung in den Bereichen des Halbleiterchips, die unterhalb der in den Randbereichen angeordneten Kontakten 9 auf der Strahlungsaustrittsfläche des Leuchtdiodenchips angeordnet sind, vermindert.

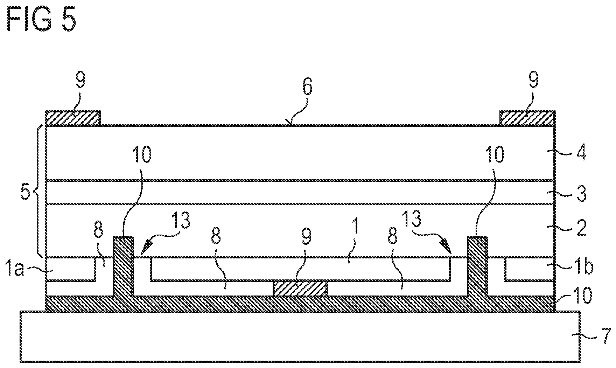

In Figur 5 ist ein weiteres Ausführungsbeispiel eines Leuchtdiodenchips dargestellt, bei dem in der Stromaufweitungsschicht 1 zwei Gräben 13 ausgebildet sind. In den Gräben erstreckt sich die metallische Schichtenfolge 10 bis in den p-Typ Halbleiterbereich 2 hinein. Die metallische Schichtenfolge 10 ist außerhalb des Bereichs des Kontakts 9 durch die Verkapselungsschicht 8 von der Stromaufweitungsschicht 1 isoliert.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Leuchtdiodenchip mit einer Halbleiterschichtenfolge (5), die ein Phosphidverbindungshalbleitermaterial aufweist, wobei die Halbleiterschichtenfolge (5)
- einen p-Typ Halbleiterbereich (2),
- einen n-Typ Halbleiterbereich (4), und
- eine zwischen dem p-Typ Halbleiterbereich (2) und dem n-Typ Halbleiterbereich (4) angeordnete aktive Schicht (3) zur Emission elektromagnetischer Strahlung enthält,
wobei der n-Typ Halbleiterbereich (4) einer Strahlungsaustrittsfläche (6) des Leuchtdiodenchips zugewandt ist, und der p-Typ Halbleiterbereich (2) einem Träger (7) des Leuchtdiodenchips zugewandt ist,
**dadurch gekennzeichnet, dass**
zwischen dem Träger und dem p-Typ Halbleiterbereich (2) eine weniger als 500 nm dicke Stromaufweitungsschicht (1) angeordnet ist, die eine oder mehrere p-dotierte AlₓGa₁₋ₓAs-Schicht (en) mit 0,5 < x ≤ 1 aufweist, und wobei mindestens eine Schicht aus InₓGa_{y}Al_{1-x-y}As mit 0 ≤ x ≤ 1, 0 ≤ y ≤ 1 und x + y ≤ 1 an die Stromaufweitungsschicht (1) angrenzt, die eine geringere Bandlücke und eine geringere Dotierstoffkonzentration als die Stromaufweitungsschicht (1) aufweist.

2. Leuchtdiodenchip nach Anspruch 1,
wobei die Stromaufweitungsschicht (1) weniger als 300 nm dick ist.

3. Leuchtdiodenchip nach Anspruch 1 oder 2,
wobei für den Aluminiumanteil x der Stromaufweitungsschicht (1) 0,6 ≤ x ≤ 0,8 gilt.

4. Leuchtdiodenchip nach einem der vorhergehenden Ansprüche,
wobei die Stromaufweitungsschicht (1) eine Dotierstoffkonzentration von mehr als 1*10¹⁹ cm⁻³ aufweist.

5. Leuchtdiodenchip nach einem der vorhergehenden Ansprüche,
wobei die Stromaufweitungsschicht (1) eine Dotierstoffkonzentration von mindestens 5*10¹⁹ cm⁻³ aufweist.

6. Leuchtdiodenchip nach einem der vorhergehenden Ansprüche,
wobei die Stromaufweitungsschicht (1) mit C dotiert ist.

7. Leuchtdiodenchip nach einem der vorhergehenden Ansprüche,
wobei die Stromaufweitungsschicht (1) einschließlich ihrer Seitenflanken (11) mit einer Verkapselungsschicht (8) versehen ist.

8. Leuchtdiodenchip nach Anspruch 7,
wobei die Verkapselungsschicht (8) Siliziumoxid, Siliziumnitrid, Zinkoxid oder ein Metall enthält.

9. Leuchtdiodenchip nach einem der vorhergehenden Ansprüche,
wobei die Stromaufweitungsschicht (1) schräge Seitenflanken (12) aufweist, die um einen Winkel zwischen einschließlich 20° und einschließlich 70° zur Schichtebene der Stromaufweitungsschicht (1) geneigt sind.

10. Leuchtdiodenchip nach einem der vorhergehenden Ansprüche,
wobei mindestens ein Graben (13) in der Stromaufweitungsschicht (1) ausgebildet ist.

11. Leuchtdiodenchip nach Anspruch 10,
wobei der mindestens eine Graben (13) mit Siliziumnitrid, Siliziumoxid, Zinkoxid oder einem Metall aufgefüllt ist.

12. Leuchtdiodenchip nach Anspruch 10 oder 11,
wobei sich der mindestens eine Graben (13) bis in den p-Typ Halbleiterbereich (2) hinein erstreckt.

13. Leuchtdiodenchip nach einem der vorhergehenden Ansprüche,
wobei ein Aufwachssubstrat von der Halbleiterschichtenfolge (5) abgelöst ist und der Träger (7) von einem Aufwachssubstrat der Halbleiterschichtenfolge (5) verschieden ist.

14. Leuchtdiodenchip nach Anspruch 13,
wobei der Träger (7) Silizium, Molybdän oder Germanium aufweist.

## Claims

1. Light-emitting diode chip comprising a semiconductor layer sequence (5) comprising a phosphide compound semiconductor material, wherein the semiconductor layer sequence (5) contains
- a p-type semiconductor region (2),
- an n-type semiconductor region (4), and
- an active layer (3) arranged between the p-type semiconductor region (2) and the n-type semiconductor region (4) and serving for emitting electromagnetic radiation,
wherein the n-type semiconductor region (4) faces a radiation exit area (6) of the light-emitting diode chip, and the p-type semiconductor region (2) faces a carrier (7) of the light-emitting diode chip,
**characterized in that**
a current spreading layer (1) having a thickness of less than 500 nm, is arranged between the carrier and the p-type semiconductor region (2), said current spreading layer having one or a plurality of p-doped AlₓGa₁₋ₓAs layer(s) with 0.5 < x ≤ 1,
and wherein at least one layer composed of InₓGa_{y}Al_{1-x-y}As where 0 ≤ x ≤ 1, 0 ≤ y ≤ 1 and x + y ≤ 1 adjoins the current spreading layer (1), and has a smaller band gap and a lower dopant concentration than the current spreading layer (1).

2. Light-emitting diode chip according to claim 1,
wherein the current spreading layer (1) has a thickness of less than 300 nm.

3. Light-emitting diode chip according to claim 1 or 2,
wherein for the aluminum proportion x of the current spreading layer (1), 0.6 ≤ x ≤ 0.8 holds true.

4. Light-emitting diode chip according to any of the preceding claims,
wherein the current spreading layer (1) has a dopant concentration of more than 1*10¹⁹cm⁻³.

5. Light-emitting diode chip according to any of the preceding claims,
wherein the current spreading layer (1) has a dopant concentration of at least 5*10¹⁹cm⁻³.

6. Light-emitting diode chip according to any of the preceding claims,
wherein the current spreading layer (1) is doped with C.

7. Light-emitting diode chip according to any of the preceding claims,
wherein the current spreading layer (1) including its side flanks (11) is provided with an encapsulation layer (8).

8. Light-emitting diode chip according to claim 7,
wherein the encapsulation layer (8) contains silicon oxide, silicon nitride, zinc oxide or a metal.

9. Light-emitting diode chip according to any of the preceding claims,
wherein the current spreading layer (1) has oblique side flanks (12), which are inclined by an angle of between 20° and 70° inclusive with respect to the layer plane of the current spreading layer (1).

10. Light-emitting diode chip according to any of the preceding claims,
wherein at least one trench (13) is formed in the current spreading layer (1).

11. Light-emitting diode chip according to claim 9,
wherein the at least one trench (13) is filled with silicon nitride, silicon oxide, zinc oxide or a metal.

12. Light-emitting diode chip according to claim 9 or 10,
wherein the at least one trench (13) extends right into the p-type semiconductor region (2).

13. Light-emitting diode chip according to any one of the preceding claims,
wherein a growth substrate is detached from the semiconductor layer sequence (5) and the carrier (7) is different than a growth substrate of the semiconductor layer sequence (5).

14. Light-emitting diode chip according to claim 13,
wherein the carrier (7) comprises silicon, molybdenum or germanium.

## Revendications

1. Puce de diode électroluminescente comprenant une succession de couches semi-conductrices (5), qui présente une matière semi-conductrice à liaison de phosphure, la succession de couches semi-conductrices (5) contenant
- une région semi-conductrice (2) de type p,
- une région semi-conductrice (4) de type n, et
- une couche active (3) disposée entre la région semi-conductrice (2) de type p et la région semi-conductrice (4) de type n, destinée à émettre un rayonnement électromagnétique,
la région semi-conductrice (4) de type n étant orientée vers une surface de sortie de rayonnement (6) de la puce de diode électroluminescente, et la région semi-conductrice (2) de type p étant orientée vers un support (7) de la puce de diode électroluminescente,
**caractérisée en ce qu'**
entre le support et la région semi-conductrice (2) de type p est disposée une couche de propagation de courant (1) d'une épaisseur de moins de 500 nm, laquelle présente une ou plusieurs couches Alₓ Ga₁₋ₓAs dopées p, avec 0,5 < x ≤ 1, et au moins une couche constituée de InₓGa_{y}Al_{1-x-y}As, avec 0 ≤ x ≤ 1, 0 ≤ y ≤ 1 et x + y ≤ 1, étant adjacente à la couche de propagation de courant (1), laquelle présente une bande interdite plus petite et une concentration de dopant plus petite que la couche de propagation de courant (1).

2. Puce de diode électroluminescente selon la revendication 1,
la couche de propagation de courant (1) étant d'une épaisseur inférieure à 300 nm.

3. Puce de diode électroluminescente selon la revendication 1 ou 2,
la proportion d'aluminium x de la couche de propagation de courant (1) étant 0,6 ≤ x ≤ 0,8.

4. Puce de diode électroluminescente selon l'une quelconque des revendications précédentes,
la couche de propagation de courant (1) présentant une concentration de dopant de plus de 1*10¹⁹ cm⁻³.

5. Puce de diode électroluminescente selon l'une quelconque des revendications précédentes,
la couche de propagation de courant (1) présentant une concentration de dopant d'au moins 5*10¹⁹ cm⁻³.

6. Puce de diode électroluminescente selon l'une quelconque des revendications précédentes,
la couche de propagation de courant (1) étant dopée au C.

7. Puce de diode électroluminescente selon l'une quelconque des revendications précédentes,
la couche de propagation de courant (1), y compris ses flancs latéraux (11), étant pourvue d'une couche d'encapsulage (8).

8. Puce de diode électroluminescente selon la revendication 7,
la couche d'encapsulage (8) contenant de l'oxyde de silicium, du nitrure de silicium, de l'oxyde de zinc ou un métal.

9. Puce de diode électroluminescente selon l'une quelconque des revendications précédentes,
la couche de propagation de courant (1) présentant des flancs latéraux (12) obliques qui sont inclinés d'un angle compris entre, y compris, 20° et, y compris, 70° par rapport au plan de couche de la couche de propagation de courant (1).

10. Puce de diode électroluminescente selon l'une quelconque des revendications précédentes,
au moins une tranchée (13) étant réalisée dans la couche de propagation de courant (1).

11. Puce de diode électroluminescente selon la revendication 10,
l'au moins une tranchée (13) étant remplie avec du nitrure de silicium, de l'oxyde de silicium, de l'oxyde de zinc ou un métal.

12. Puce de diode électroluminescente selon la revendication 10 ou 11,
l'au moins une tranchée (13) s'étendant jusque dans la région semi-conductrice (2) de type p.

13. Puce de diode électroluminescente selon l'une quelconque des revendications précédentes,
un substrat de croissance étant détaché de la succession de couches semi-conductrices (5), et le support (7) étant différent d'un substrat de croissance de la succession de couches semi-conductrices (5).

14. Puce de diode électroluminescente selon la revendication 13,
le support (7) présentant du silicium, du molybdène ou du germanium.
